# EUROPEAN PATENT APPLICATION

(11) **EP 1 482 594 A1**
(43) Date of publication of application: **01.12.2004**
(21) Application number: 04012084.2
(22) Date of filing: 21.05.2004
(51) Int. Cl.: H01R 12/04

(54) **A terminal**

(30) Priority: 30.05.2003 JP 2003154260
(71) Applicant: Sumitomo Wiring Systems, Ltd., Yokkaichi-City, Mie, 510-8503 (JP)
(72) Inventor: Tsuchiya, Takashi, c/o Sumitomo Wiring Systems,L., Yokkaichi-city, Mie 510-8503 (JP)
(74) Representative: Müller-Boré & Partner Patentanwälte

(57) **Abstract**

An object of the present invention is to provide a terminal which can be used for a wide range of through holes from those having smaller diameters to those having larger diameters.

A terminal 10 is provided with a pair of high-rigidity portions 14 to resiliently come into contact with the inner circumferential surface of a through hole 23, and a low-rigidity portion 17 which spans between the two high-rigidity portions 14 and is compressively deformable along its spanning direction. The low-rigidity portion 17 is formed with an easily breakable portion 19 which is broken when a stress acting during the insertion of the terminal 10 into the through hole 23 exceeds a resiliency limit. Thus, the terminal 10 is resiliently held in contact with a through hole 23 having a large diameter by resilient forces of the two high-rigidity portions 14 and a resilient force of the low-rigidity portion 17 while being resiliently held in contact with a through hole 23 having a small diameter by the resilient forces of the two high-rigidity portions 14.

## Description

The present invention relates to a terminal to be mounted on an electric or electronic device such as a circuit board.

Conventionally, so-called press-fit terminals have been inserted into through holes of a circuit board without being soldered to be electrically connected with contact portions formed on the inner circumferential surfaces of these through holes. Among press-fit terminals, those having a shape called needle eye are enabled to undergo radial resilient deformations by being formed to have a pair of resilient contact portions which bulge out in a substantially arcuate manner while defining a deformation space therebetween (see, for example, Japanese Unexamined Patent Publication No. S58-123678 and Japanese Unexamined Patent Publication No. H11-16656). This terminal is inserted into a through hole of a circuit board while both resilient contact portions are resiliently deformed in directions closing the deformation space, and the resilient contact portions are pressed against the inner circumferential surface of the through hole and establish an electrical connection with the contact portion of the through hole by their resilient forces acting in directions opening the deformation space.

However, the terminal of the above type may not ensure a sufficient terminal holding force due to reduced resilient reaction forces of the resilient contact portions when the diameter of the through hole is large although being enable to ensure a sufficient terminal holding force by the resilient reaction forces when the diameter of the through hole is small.

The present invention was developed in view of the above problem and an object thereof is to provide a terminal which can be used for a wide range of holes from those having smaller diameters to those having larger diameters.

This object is solved according to the invention by a terminal according to claim 1. Preferred embodiments are subject of the dependent claims.

According to the invention, there is provided a terminal at least partly insertable into a hole of an electric or electronic device such as a circuit board to establish an electrical connection with a contact portion at least partly formed on or at the inner surface of the hole, comprising:
at least one pair of high-rigidity portions formed to substantially face each other with the opposite longitudinal ends thereof coupled and to resiliently come into contact with at least part of the inner circumferential surface of the hole, and
at least one low-rigidity portion spanning between the two high-rigidity portions and compressively deformable substantially along its spanning direction,
wherein the low-rigidity portion is formed with an easily breakable portion which is breakable when a stress acting during the insertion into the hole exceeds a resiliency limit.

According to a preferred embodiment of the invention, there is provided a circuit board terminal at least partly insertable into a through hole of a circuit board to establish an electrical connection with a contact portion formed on the inner circumferential surface of the through hole, comprising:
a pair of high-rigidity portions formed to face each other with the opposite longitudinal ends thereof coupled and to resiliently come into contact with the inner circumferential surface of the through hole, and
a low-rigidity portion spanning between the two high-rigidity portions and compressively deformable along its spanning direction,
wherein the low-rigidity portion is formed with an easily breakable portion which is broken when a stress acting during the insertion into the through hole exceeds a resiliency limit.

The terminal is inserted into the through hole of the circuit board while the low-rigidity portion is compressively deformed and the pair of high-rigidity portions are resiliently deformed in closing directions. Then, the high-rigidity portions are pressed against the inner circumferential surface of the through hole by a resilient force of the low-rigidity portion and resilient forces of the high-rigidity portions. Thus, an electrical connection with the contact portion is established while the terminal is prevented from coming out of the through hole. Since the high-rigidity portions are resiliently held substantially in contact with (at least part of) the inner circumferential surface of the through hole by a sum of the resilient force of the low-rigidity portion and the resilient forces of the high-rigidity portions, a sufficient contact pressure can be ensured and a highly reliable electrical connection can be established with the contact portion even if the through hole has a large diameter.

The terminal is resiliently held or holdable substantially in contact with the through hole having a large diameter by the sum of the resilient force of the low-rigidity portion and the resilient forces of the high-rigidity portions as described above. On the other hand, when the terminal is at least partly inserted into a through hole having a small diameter, the stress acting on the low-rigidity portion exceeds the resiliency limit and the easily breakable portion is broken. Thus, the terminal is resiliently held or holdable substantially in contact with the through hole having a small diameter only by the resilient forces of the high-rigidity portions since the resilient force of the low-rigidity portion disappears as the easily breakable portion is broken. Then, a terminal inserting force is reduced during the insertion of the terminal into the through hole, and the terminal can be resiliently held substantially in contact with the through hole having a small diameter at a suitable contact pressure coming from the resilient forces of the high-rigidity portions. Therefore, the terminal of the present invention can be used for various through holes in a wide range from those having smaller diameters to those having larger diameters.

Preferably, the low-rigidity portion has a smaller cross-section, preferably is thinner than the high-rigidity portions and/or is formed to be unitary or integral to the high-rigidity portions.

Since the low-rigidity portion preferably is thinner than the high-rigidity portions and/or formed to be unitary integral to the high-rigidity portions, it can be easily produced and easily handled.

Further preferably, the easily breakable portion which is breakable when the diameter of the contact portion on the inner circumferential surface of the hole is smaller than a distance between substantially opposite outer portions of the high-rigidity portions by about 5% to about 20 %, more preferably by about 8% to about 17%.

Still further preferably, the easily breakable portion is formed to substantially longitudinally extend from the one end to the other end of the low-rigidity portion and/or to laterally extend from the one end to the other end of the low-rigidity portion.

Most preferably, as the easily breakable portion is broken, a pair of split pieces are formed in the low-rigidity portion at the substantially opposite sides of the easily breakable portion.

According to a further preferred embodiment of the invention, the outer surfaces of the high-rigidity portions are formed into substantially straight portion preferably over an area more than 1/4 of, preferably over an area about 1/3 of the entire length of the high-rigidity portions.

Preferably, the substantially straight portions are substantially parallel with each other and/or substantially arranged along an inserting direction ID of the terminal into the hole.

Further preferably, the substantially straight portions have substantially arcuate surfaces substantially along the inner circumferential surface of the through hole with respect to width direction.

Most preferably, the high-rigidity portions and the low-rigidity portion are formed to be substantially point-symmetrical with respect to a radial middle point or axis of the terminal.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a front view of a terminal according to one embodiment of the invention,
FIG. 2 is a side view of the terminal,
FIG. 3 is a front view partly in section showing an operation of inserting the terminal into a through hole of a printed circuit board,
FIG. 4 is an enlarged section along X-X of FIG. 3,
FIG. 5 is a front view partly in section showing a state when the insertion of the terminal into a through hole having a small diameter is completed,
FIG. 6 is an enlarged section along Y-Y of FIG. 5, and
FIG. 7 is a diagram corresponding to FIG. 6 showing a state when the insertion of the terminal into a through hole having a large diameter is completed.

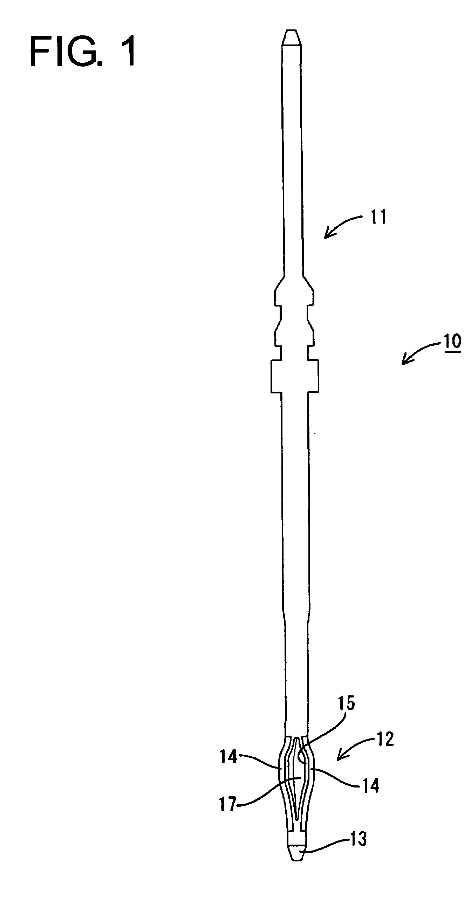

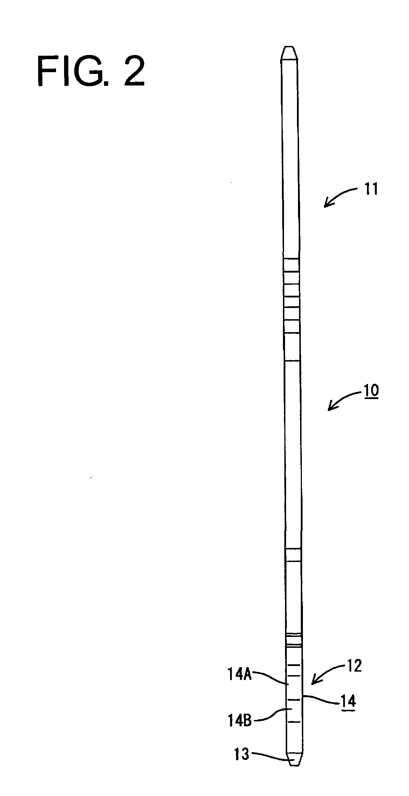

Hereinafter, one preferred embodiment of the present invention is described with reference to FIGS. 1 to 7. A terminal 10 of this embodiment is also called a press-fit terminal, and substantially formed into a narrow and long (preferably substantially rectangular) bar as a whole preferably by press-working a conductive (preferably metallic) wire or workpiece having an excellent electrical conductivity. This terminal 10 is bent, for example, in L-shape, and a mounting portion 11 at one end is to be at least partly mounted into an unillustrated circuit board connector, for example, by being at least partly pressed thereinto, whereas a board connecting portion 12 (as a preferred connecting portion for connection with an electric or electronic device such as a printed circuit board) at the other end is to be at least partly inserted in an inserting direction ID into a through hole 23 of a printed circuit board 20 or the like electric or electronic element.

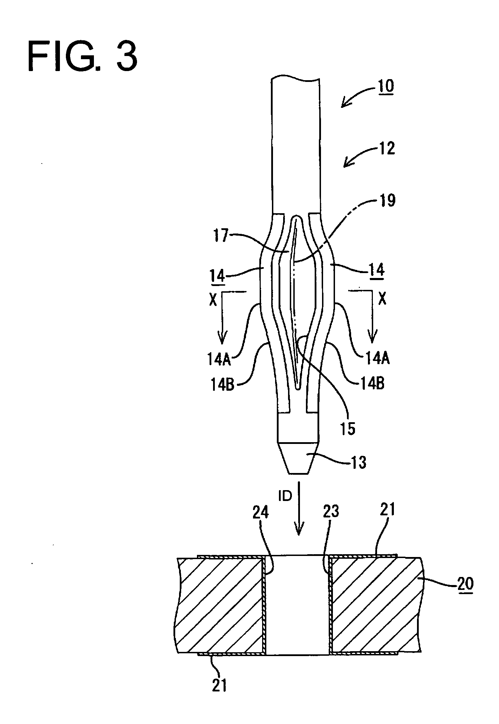

As shown in FIG. 3, the printed circuit board 20 has one or more, preferably various conductor paths 21 at least partly formed in and/or on its outer surfaces and is formed with one or more through holes 23. A contact portion 24 is at least partly formed on the inner circumferential surface of each through hole 23 preferably by plating and to be connected with the conductor paths 21.

Next, the board connecting portion 12 of the terminal 10 is described in detail. As shown in FIG. 3, the board connecting portion 12 has a guiding (preferably tapered or rounded or converging) portion 13 formed at the leading end, and one or more, preferably a pair of high-rigidity portions 14 are formed above or behind the tapered portion 13 (as seen in the inserting direction ID) over an area extending more than the depth of the through hole 23, preferably about twice the depth of the through hole 23 or more. The respective high-rigidity portions 14 are thick strips or elements and bulge radially outward preferably in a substantially arcuate manner while defining a deformation space 15 therebetween. At a position slightly above or behind the longitudinal middle of the high-rigidity portions 14, the outer surfaces of the high-rigidity portions 14 are formed into substantially straight portion 14A preferably over an area more than 1/4 of, preferably over an area about 1/3 of the entire length and are substantially parallel with each other and/or substantially arranged along the inserting direction ID. The straight portions 14A preferably have substantially arcuate surfaces along the inner circumferential surface of the through hole 23 with respect to width direction. Specifically, both high-rigidity portions 14 have the opposite longitudinal or lateral ends 14', 14" coupled to each other and are resiliently deformable to open and close the deformation space 15 substantially in radial directions. In other words, one lateral portion 14' of one high-rigidity portion 14 is coupled to a substantially opposite lateral portion 14" of the other high-rigidity portion 14 by means of the low-rigidity portion 17 to be described later. The lateral portions 14', 14" preferably are faces of the high-rigidity portions 14 facing in a direction different, preferably substantially normal to the direction along which the high-rigidity portions 14 are deflected upon insertion into the through hole 23.

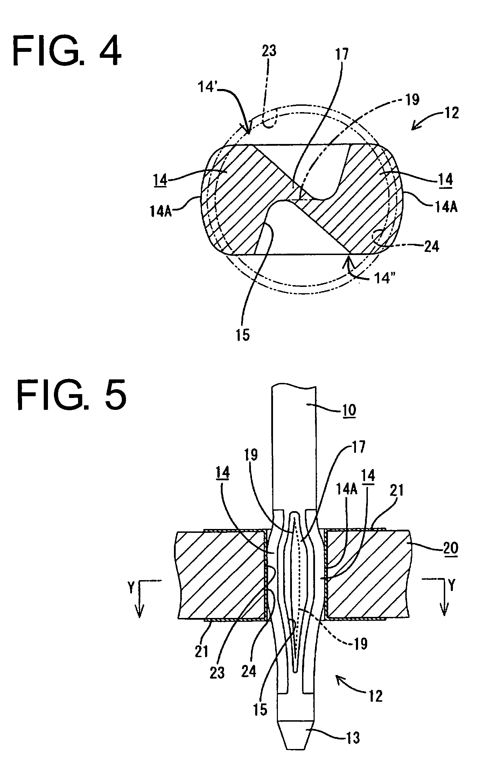

A low-rigidity portion 17 thinner or having a smaller cross section than the high-rigidity portions 14 is integrally or unitarily formed between the substantially facing inner surfaces of the high-rigidity portions 14. This low-rigidity portion 17 preferably is substantially plate-shaped and at least partly obliquely spans between the respective high-rigidity portions 14 in such a manner as to couple one widthwise edge (upper edge in FIG. 4) of one high-rigidity portion 14 and the other widthwise edge of the other high-rigidity portion 14 as shown in FIG. 4. Further, the low-rigidity portion 17 is so formed as to be thinner or smaller cross section in the intermediate position, preferably in middle with respect to its spanning direction and to be gradually thicker toward the opposite ends thereof coupled to the high-rigidity portions 14.

The two high-rigidity portions 14 and the low-rigidity portion 17 are formed to have a slightly flat Z- or N-shape as a whole, i.e. is substantially point-symmetrical (refer e.g. to FIG. 4). In other words, substantially opposite edge portions 14', 14" of the respective high-rigidity portions 14 are connected by the low-rigidity portion 17 extending substantially across the (imaginary) radial middle point (or longitudinal axis) of the terminal 10 while preferably first decreasing in thickness or cross-section towards the (imaginary) radial middle point and then increasing again so as to be preferably point-symmetrical with respect to the middle point (FIG. 4). Preferably the high-rigidity portions 14 have such a cross-section or shape and/or are made by such a material so as to have a rigidity which is more than about twice as high as the rigidity of the low-rigidity portion 17, the rigidity of the low-rigidity portion 17 being determined by its cross-section and/or material. Particularly, the force needed for deforming the high-rigidity portion(s) 14 is more than about twice as high as the force needed for deforming the low-rigidity portion 17.

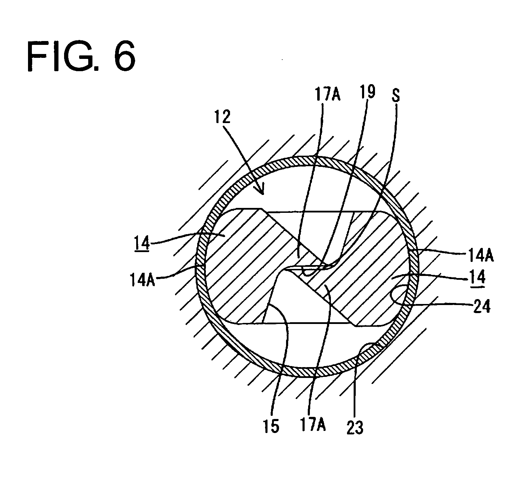

The low-rigidity portion 17 is formed with an easily breakable portion 19 which is broken as a stress exceeds a specific (predetermined or predeterminable) resiliency limit when the board connecting portion 12 is at least partly inserted into the through hole 23 having a smaller diameter (preferably when the diameter of the contact portion 24 on the inner circumferential surface of the through hole 23 is smaller than a distance between the straight portions 14A of the two high-rigidity portions 14 by about 5 to about 20 %). This easily breakable portion 19 preferably is formed to substantially longitudinally extend from the one end to the other end of the low-rigidity portion 17 and/or (also) to laterally or radially extend from the one end to the other end of the low-rigidity portion 17 as shown in FIG. 6. As the easily breakable portion 19 is broken, a pair of split pieces 17A are formed in the low-rigidity portion 17 at the substantially opposite sides of the easily breakable portion 19.

Next, the functions of this embodiment are described. The board connecting portion 12 of the terminal 10 is at least partly inserted in the inserting direction ID into the corresponding through hole 23 of the printed circuit board 20 e.g. from above as indicated by an arrow in FIG. 3. During the insertion, leading or lower slanted portions 14B on the outer surfaces of the high-rigidity portions 14 come substantially into contact with the upper opening edge of the through hole 23. The terminal 10 is further pushed thereinto while the high-rigidity portions 14 are so resiliently deformed inwardly as to at least partly close the deformation space 15 by being guided by the slanted portions 14B. When the board connecting portion 12 is pushed until the substantially straight portions 14A on the outer surfaces of the high-rigidity portions 14 reach an intermediate position, preferably a middle depth position of the through hole 23, the insertion is completed.

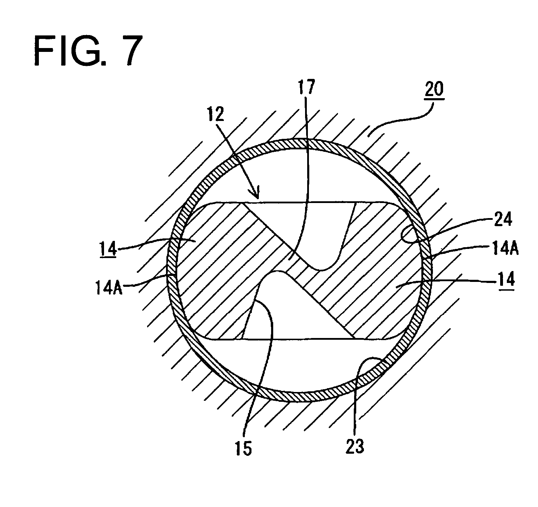

In this case, if the diameter of the through hole 23 is large, the low-rigidity portion 17 maintains substantially its state while being slightly compressively deformed along its spanning direction as shown in FIG. 7. Accordingly, the straight portions 14A on the outer surfaces of the two high-rigidity portions 14 are strongly pressed against the inner circumferential surface of the through hole 23 due to a resilient force of the low-rigidity portion 17 in its elongating direction (or radially outwardly) and the resilient forces of the high-rigidity portions 14 in the opening directions.

Contrary to this, if the through hole 23 has a small diameter, a stress acting on the low-rigidity portion 17 during the insertion exceeds the specific resiliency limit and the easily breakable portion 19 is at least partly broken. Then, as shown in FIG. 6, the respective split pieces 17A located at the opposite sides of the easily breakable portion 19 are displaced from each other toward the facing high-rigidity portions 14 along the easily breakable portion 19, and the leading ends thereof come substantially into contact with or proximity to the inner surfaces of the facing high-rigidity portions 14. In this state, a slight clearance S is defined between the substantially facing surfaces of the respective split pieces 17A. In this case, the substantially straight portions 14A on the outer surfaces of the two high-rigidity portions 14 are pressed against the inner circumferential surface of the small-diameter through hole 23 at a suitable contact pressure only by the resilient forces of the high-rigidity portions 14 in the opening directions without being assisted by the resilient force of the low-rigidity portion 17.

As described above, the terminal 10 of this preferred embodiment can establish a highly reliable electrical connection with the contact portion 24 formed on the inner circumferential surface of the through hole 23 while ensuring a sufficient contact pressure regardless of whether the diameter of the through hole 23 is large or small.

Further, since the terminal 10 is formed such that the easily breakable portion 19 is at least partly, preferably fully broken when the stress acting on the low-rigidity portion 17 during the insertion of the terminal 10 into the through hole 23 having a small diameter exceeds the specific (predetermined or predeterminable) resiliency limit, it is inserted into this through hole 23 with a terminal inserting force reduced. Thus, an operation burden during the insertion of the terminal can be reduced.

Accordingly, to provide a terminal which can be used for a wide range of through holes of an electric or electronic device such as a circuit board from those having smaller diameters to those having larger diameters, a terminal 10 is provided with one or more, preferably a pair of high-rigidity portions 14 to resiliently come substantially into contact with the inner circumferential surface of a through hole 23, and a low-rigidity portion 17 which spans between or connects inwardly oriented parts of the two high-rigidity portions 14 and is compressively deformable along its spanning direction or radial direction. The low-rigidity portion 17 is formed with an easily breakable portion 19 which is to be broken when a stress acting during the insertion of the terminal 10 into the through hole 23 exceeds a specific (predetermined or predeterminable) resiliency limit. Thus, the terminal 10 is resiliently held in contact with a through hole 23 having a relatively large diameter by resilient forces of the two high-rigidity portions 14 and a resilient force of the low-rigidity portion 17 while being resiliently held in contact with a through hole 23 having a relatively small diameter by the resilient forces of the two high-rigidity portions 14.

### <Other Embodiments>

The present invention is not limited to the above described and illustrated embodiment. For example, the following embodiments are also embraced by the technical scope of the present invention as defined by the claims. Beside the following embodiments, various changes can be made without departing from the scope and spirit of the present invention as defined by the claims.
(1) The shape and orientation of the low-rigidity portion can be arbitrarily set provided that the low-rigidity portion is formed with the easily breakable portion which is broken when the stress acting during the insertion into the through hole exceeds the resiliency limit.
(2) A means for breaking the breakable portion is not limited to the thinning of the low-rigidity portion, and the low-rigidity portion may be made of an easily breakable material or a combination thereof.
(3) The breakable portion may be formed, for example, by forming the low-rigidity portion with a slit extending substantially in a breaking direction.
(4) Even though the terminal 10 has been described as being at least partly fittable into a through hole 23 provided in the printed circuit board 20, it should be understood that it may be used in connection with bottomed holes having a sufficient depth for an at least partial insertion of the terminal thereinto so as to establish an electric connection with the contact portion 24 of the bottomed hole 23.
(4) The terminal according to the invention has been described with reference to its insertion in a through hole provided on a printed circuit board. However, it should be understood that the terminal according to the invention may be used for other electric or electronic devices having a bottomed or through hole for electric connection such as electric appliances, junction boxes, connectors, etc.

### LIST OF REFERENCE NUMERALS

- 10: terminal
- 12: board connecting portion
- 14: high-rigidity portion
- 17: low-rigidity portion
- 19: easily breakable portion
- 20: printed circuit board
- 23: through hole
- 24: contact portion

## Claims

1. A terminal (10) at least partly insertable into a hole (23) of an electric or electronic device (20) to establish an electrical connection with a contact portion (24) at least partly formed on or at the inner surface of the hole (23), comprising:
at least one pair of high-rigidity portions (14) formed to substantially face each other with the opposite longitudinal ends (14', 14") thereof coupled and to resiliently come into contact with at least part of the inner circumferential surface of the hole (23), and
at least one low-rigidity portion (17) spanning between the two high-rigidity portions (14) and compressively deformable substantially along its spanning direction,
wherein the low-rigidity portion (17) is formed with an easily breakable portion (19) which is breakable when a stress acting during the insertion into the hole (23) exceeds a resiliency limit.

2. A terminal according to claim 1, wherein the low-rigidity portion (17) is formed to have a smaller cross-section, preferably thinner than the high-rigidity portions (14).

3. A terminal according to one or more of the preceding claims, wherein the low-rigidity portion (17) is formed to be unitary or integral to the high-rigidity portions (14).

4. A terminal according to one or more of the preceding claims, wherein the easily breakable portion (19) which is breakable when the diameter of the contact portion (24) on the inner circumferential surface of the hole (23) is smaller than a distance between substantially opposite outer portions (14A) of the high-rigidity portions (14) by about 5% to about 20 %, more preferably by about 8% to about 17%.

5. A terminal according to one or more of the preceding claims, wherein the easily breakable portion (19) is formed to substantially longitudinally extend from the one end to the other end of the low-rigidity portion (17) and/or to laterally extend from the one end to the other end of the low-rigidity portion (17).

6. A terminal according to one or more of the preceding claims, wherein as the easily breakable portion (19) is broken, a pair of split pieces (17A) are formed in the low-rigidity portion (17) at the substantially opposite sides of the easily breakable portion (19).

7. A terminal according to one or more of the preceding claims, wherein the outer surfaces of the high-rigidity portions (14) are formed into substantially straight portion (14A) preferably over an area more than 1/4 of, preferably over an area about 1/3 of the entire length of the high-rigidity portions (14).

8. A terminal according to claim 7, wherein the substantially straight portions (14A) are substantially parallel with each other and/or substantially arranged along an inserting direction ID of the terminal into the hole (24).

9. A terminal according to claim 7 or 8, wherein the substantially straight portions (14A) have substantially arcuate surfaces substantially along the inner circumferential surface of the through hole (23) with respect to width direction.

10. A terminal according to one or more of the preceding claims, wherein the high-rigidity portions (14) and the low-rigidity portion (17) are formed to be substantially point-symmetrical with respect to a radial middle point or axis of the terminal (10).
